# EUROPEAN PATENT SPECIFICATION

(11) **EP 3 444 844 B1**
(45) Date of publication and mention of the grant of the patent: **25.08.2021**
(21) Application number: 18161162.5
(22) Date of filing: 12.03.2018
(51) Int. Cl.: H01L 27/146, H01L 31/0203

(54) **STACK TYPE SENSOR PACKAGE STRUCTURE**
STAPELARTIGE SENSORGEHÄUSESTRUKTUR
STRUCTURE DE BOÎTIER DE CAPTEUR DE TYPE À EMPILEMENT

(30) Priority: 15.08.2017 US 201762545542 P; 27.10.2017 CN 201711020975
(43) Date of publication of application: 20.02.2019
(73) Proprietor: Kingpak Technology Inc., Hsin-Chu Hsien (TW)
(72) Inventor: CHEN, Jian -Ru, Chu-Pei, Hsin-Chu County (TW); YANG, Jo-Wei, Chu-Pei, Hsin-Chu County (TW); HUNG, Li-Chun, Chu-Pei, Hsin-Chu County (TW); TU, Hsiu-Wen, Chu-Pei, Hsin-Chu County (TW)
(74) Representative: Viering, Jentschura & Partner mbB Patent- und Rechtsanwälte

(56) References cited:
- JP-A- 2002 353 427
- US-A1- 2008 267 616
- US-A1- 2013 221 470

## Description

### BACKGROUND OF THE INVENTION

### 1. Field of the Invention

The disclosure relates to a sensor package structure; in particular, to a stack type sensor package structure.

### 2. Description of Related Art

While multiple chips are being set up within a conventional sensor package structure, the method of disposing the chips may affect stability of wire bonding and result in various defects in the sensor package structure. For example, when a conventional sensor package structure includes a semiconductor chip of a larger size and a sensor chip of a smaller size, with the sensor chip being adhered on the semiconductor chip, a relatively large force is required for bonding a wire to the periphery of the sensor chip, which however of ten damages the sensor chip. Documents JP 2002 353427 and US 2013/221470 show stack type sensor package structures.

### SUMMARY OF THE INVENTION

The disclosure provides a stack type sensor package structure to effectively improve the defects potentially caused by conventional sensor package structures.

The invention provides a stack type sensor package structure as defined in claim 1. The disclosure discloses a stack type sensor package structure, which includes a substrate, at least one semiconductor chip, a frame, a sensor chip, a plurality of wires, a transparent layer, a support, and a package compound. The substrate has an upper surface and a lower surface opposite to the upper surface. The substrate includes a plurality of solder pads arranged on the upper surface. The at least one semiconductor chip is mounted on the substrate. The frame is fixed on the upper surface of the substrate and is surrounded by the solder pads. The at least one semiconductor chip is in a space defined by the frame and the substrate and does not contact the frame, and the frame has a bearing plane above the at least one semiconductor chip. The sensor chip has a top surface and a bottom surface opposite to the top surface. The sensor chip includes a plurality of connecting pads arranged on the top surface thereof. A size of the sensor chip is larger than that of the at least one semiconductor chip, and the bottom surface of the sensor chip is fixed on the bearing plane. Each of the wires has a first end and a second end opposite to the first end. The first ends of the wires are respectively connected to the solder pads, and the second ends of the wires are respectively connected to the connecting pads. The transparent layer has a first surface and a second surface opposite to the first surface. The second surface has a central region and a ring-shaped supported region encircling the central region. The support has a ring-shaped structure and is disposed on at least one of the top surface of the sensor chip and the bearing surface of the frame. A top end of the support abuts against the supported region of the transparent layer. The package compound is disposed on the upper surface of the substrate and covers a lateral side of the frame, at least part of a lateral side of the transparent layer, and a lateral side of the support. At least part of each of the wires is embedded in the package compound.

Within the stack type sensor package structure according to one embodiment of the disclosure, the frame is disposed on the substrate so that the structural strength of the stack type sensor package structure can be increased, and the sensor chip can be disposed on the more stable frame, thereby controlling levelness of the sensor chip. Furthermore, because the wire bonding region of the sensor chip is supported by the frame, the wires can be effectively connected to the wire bonding region of the sensor chip during the wire bonding process so as to prevent other components from being damaged.

Moreover, the sensor chip and the semiconductor chip of the stack type sensor package structure are separated from each other by the frame , so the sensor chip is less directly affected by heat energy generated from the semiconductor chip. Heat from the semiconductor chip can be dissipated by conduction through the substrate, thus heat dissipating performance of the stack type sensor package structure is effectively enhanced.

In addition, according to one embodiment of the disclosure, a through hole is formed in the frame. Thus, when the adhesive (not shown in the drawings) between the frame and the substrate is baked, air between the frame and the substrate expands as it is heated and exhausts via the through hole, thereby maintaining levelness of the bearing plane of the frame.

In order to further appreciate the characteristics and technical contents of the disclosure, references are hereunder made to the detailed descriptions and appended drawings in connection with the disclosure. However, the appended drawings are merely shown for exemplary purposes, and should not be construed as restricting the scope of the disclosure.

### BRIEF DESCRIPTION OF THE DRAWINGS

Fig. 1 is a cross-sectional view showing a stack type sensor package structure according to a first embodiment not making part of the invention;
Fig. 2 is a cross-sectional view showing the stack type sensor package structure according to a second embodiment not making part of the invention;
Fig. 3 is a cross-sectional view showing the stack type sensor package structure according to a third embodiment not making part of the invention;
Fig. 4 is a cross-sectional view showing the stack type sensor package structure according to a fourth embodiment not making part of the invention;
Fig. 5A is a cross-sectional view showing the stack type sensor package structure according to a fifth embodiment not making part of the invention;
Fig. 5B is a cross-sectional view showing the stack type sensor package structure in another configuration according to the fifth embodiment not making part of the invention;
Fig. 6 is a cross-sectional view showing the stack type sensor package structure according to a sixth embodiment not making part of the invention;
Fig. 7 is a cross-sectional view showing the stack type sensor package structure according to a seventh embodiment defining the invention;
Fig. 8 is a cross-sectional view showing the stack type sensor package structure according to an eighth embodiment defining the invention;
Fig. 9 is a cross-sectional view showing the stack type sensor package structure according to a ninth embodiment defining the invention;
Fig. 10 is a cross-sectional view showing the stack type sensor package structure according to a tenth embodiment defining the invention;
Fig. 11 is a cross-sectional view showing the stack type sensor package structure according to an eleventh embodiment defining the invention;
Fig. 12 is a cross-sectional view showing the stack type sensor package structure according to a twelfth embodiment not making part of the invention;
Fig. 13 is a cross-sectional view showing the stack type sensor package structure according to a thirteenth embodiment not making part of the invention;
Fig. 14A is a cross-sectional view showing the stack type sensor package structure according to a fourteenth embodiment not making part of the invention;
Fig. 14B is a cross-sectional view showing the stack type sensor package structure in another configuration according to a fourteenth embodiment not making part of the invention;
Fig. 15 is a cross-sectional view showing the stack type sensor package structure according to a fifteenth embodiment not making part of the invention;
Fig. 16 is a cross-sectional view showing the stack type sensor package structure according to a sixteenth embodiment not making part of the invention;
Fig. 17 is a cross-sectional view showing the stack type sensor package structure according to a seventeenth embodiment not making part of the invention;
Fig. 18 is a cross-sectional view showing the stack type sensor package structure according to an eighteenth embodiment not making part of the invention;
Fig. 19 is a cross-sectional view showing the stack type sensor package structure according to a nineteenth embodiment not making part of the invention; and
Fig. 20 is a cross-sectional view showing the stack type sensor package structure according to a twentieth embodiment defining the invention.

### DETAILED DESCRIPTION OF THE PREFERRED EMBODIMENTS

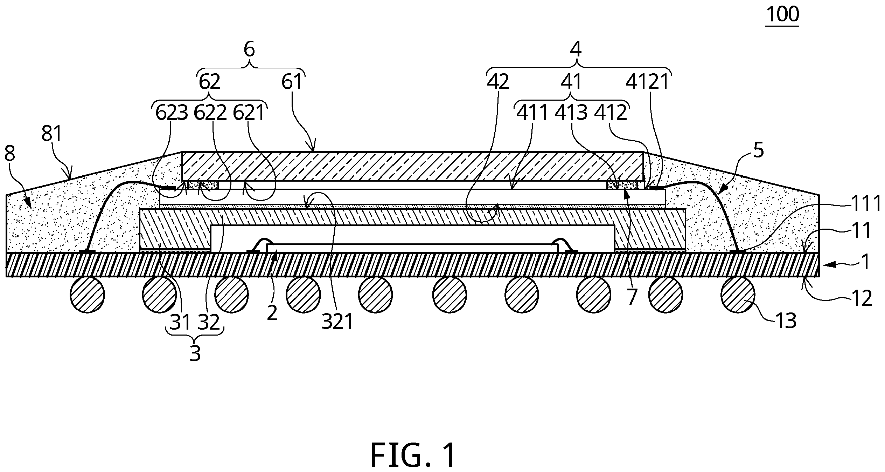

Reference is made to Figs. 1 to 20. References are hereunder made to the detailed descriptions and appended drawings in connection with the disclosure. However, the appended drawings are merely provided for exemplary purposes, and should not be construed as restricting the scope of the disclosure.

### [First Embodiment not making part of the invention]

As illustrated in Fig. 1, the present embodiment discloses a stack type sensor package structure 100, particularly an image sensor package structure, but the disclosure is not limited thereto. The stack type sensor package structure 100 includes a substrate 1, a semiconductor chip 2 disposed on the substrate 1, a frame 3 disposed on the substrate 1 and arranged outside the semiconductor chip 2, a sensor chip 4 disposed on the frame 3, a plurality of wires 5 electrically connecting the substrate 1 and the sensor chip 4, a transparent layer 6 at a position corresponding to the sensor chip 4, a support 7 configured to maintain the relative position between the transparent layer 6 and the sensor chip 4, and a package compound 8 disposed on the substrate 1 and covering the frame 3, the support 7, and the transparent layer 6. In the following description, the structure of each component of the stack type sensor package structure 100 is elaborated. Interconnections between the components will be described as well.

The substrate 1 in the present embodiment can be a plastic substrate, a ceramic substrate, a lead frame, or other laminated materials, and the disclosure is not limited thereto. The substrate 1 has an upper surface 11 and a lower surface 12 opposite to the upper surface 11. The substrate 1 includes a plurality of solder pads 111 arranged at intervals on the upper surface 11. Furthermore, the substrate 11 also includes a plurality of solder pads (not labeled) arranged on the lower surface 12 to which a plurality of solder balls 13 are respectively connected. In other words, the solder balls 13 are arranged in an array on the lower surface 12 of the substrate 1, and the substrate 1 is exemplified as a ball grid array (BGA) substrate, but the disclosure is not limited thereto.

The semiconductor chip 2 in the present embodiment is mounted on the upper surface 11 of the substrate 1 and is electrically connected to the substrate 1 by wire bonding, but the disclosure is not limited thereto. Moreover, the type of the semiconductor chip 2 can be determined according to design requirements. For example, the semiconductor chip 2 can be a processor chip or a memory chip.

The frame 3 in the present embodiment can be made of glass and is an integrally formed one-piece object. For instance, the frame 3 may be formed by excavating at the center of a bearing board to to create a square well, but the disclosure is not limited hereto. The material of the frame 3 can be a rigid material with high thermal conductivity, such as ceramic or metal. The frame 3 is fixed on the upper surface 11 of the frame 1 and surrounded by the solder pads 111. A space enclosed by the frame 3 and the substrate 1 is filled with air, and the semiconductor chip 2 is in the space and does not contact the frame 3.

Specifically, the frame 3 includes a ring-shaped base 31 and a bearing plate 32 integrally connected to a top end of the ring-shaped base 31, and a bottom end of the ring-shaped base 31 is fixed on the upper surface 11 of the substrate 1. The frame 3 can be fixed to the substrate 1 through an adhesive (not labeled) that attaches the ring-shaped base 31 to the substrate 1, and the adhesive can be a UV curing adhesive, a thermal curing adhesive, an adhesive mixture including an UV curing adhesive and a thermal curing adhesive, or an attach film. However, the disclosure is not limited thereto.

Moreover, an outer surface of the bearing plate 32 (i.e., the top surface of the bearing plate 32 as shown in Fig. 1) is above the semiconductor chip 2 and defined as a bearing plane 321. In other words, in the present embodiment, the outer surface of the bearing plate 32 having better levelness is taken as the bearing plane 321 that sustains the sensor chip 4, thereby ensuring levelness of the sensor chip 4. The frame 3 has high structural rigidity, which effectively mitigates the extent of warpage of the stack type sensor package structure 100.

In addition, the structure of the frame 3 can be adjusted or changed according to design requirements as described in the following embodiments. For example, the frame 3 can be formed with a through hole, which is specifically disclosed in the nineteenth embodiment.

The sensor chip 4 in the present embodiment is an image sensor chip, a size of which is larger than that of the semiconductor chip 2. However, the type of the sensor chip 4 of the disclosure is not limited thereto. The sensor chip 4 has a top surface 41, a bottom surface 42 opposite to the top surface 41, and a lateral side (not labeled) perpendicularly connected to the top surface 41 and the bottom surface 42. The top surface 41 of the sensor chip 4 has a sensing region 411, a wire bonding region 412 arranged on the outer side of the sensing region 411, and a bearing region 413 between the sensing region 411 and the wire bonding region 412. The sensor chip 4 includes a plurality of connecting pads 4121 arranged in the wire bonding region 412 and on the outer side of the sensing region 411.

Specifically, the sensing region 411 in the present embodiment has a roughly rectangular shape (e.g., a square or a rectangle). The center of the sensing region 411 can be aligned with (as shown in Fig. 1) the center of the top surface 41, or spaced apart by a distance from (not shown) the center. The wire bonding region 412 in the present embodiment has a square ring shape, each section of the region 412 is preferably of the same width. However, the specific shape of the wire bonding region 412 can be modified according to actual needs and is not limited thereto. For example, in other embodiments, the wire bonding region 412 can be a strip shape or an L-shape on a side of the sensing region 411, or a pair of strip shapes or an L-shapes on two opposite sides of the sensing region 411.

In another aspect, the bottom surface 42 of the sensor chip 4 is fixed to the bearing plane 321 of the frame 3, and the periphery of the bottom surface 42 of the sensor chip 4 is preferably above the ring-shaped base 31. The bottom surface 42 of the sensor chip 4 in the present embodiment is fixed on the bearing plane 321 of the frame 3 by an adhesive (die attach epoxy, not labeled), but the practical setup method is not limited thereto.

Each of the wires 5 has a first end and a second end opposite to the first end. The first ends of the wires 5 are respectively connected to the solder pads 111 of the substrate 1, and the second ends of the wires 5 are respectively connected to the connecting pads 4121 of the sensor chip 4. Each of the wires 5 can be formed by a reverse or forward bonding process. Specifically, when each of the wires 5 is formed by the reverse bonding process, an angle (not labeled) between the top surface 41 of the sensor chip 4 and a portion of each of the wires 5 adjacent to the top surface 41 is smaller than or equal to 45 degrees so that the apex of each of the wires 5 is at a lower level and thus prevented from touching the transparent layer 6. However, the disclosure is not limited thereto.

The transparent layer 6 in the present embodiment is transparent and exemplified as a glass plate; however the type of the transparent layer 6 is not limited thereto by the disclosure. For example, the transparent layer 6 can be made of a light-transmissive (or transparent) plastic material. The transparent layer 6 has a first surface 61, a second surface 62 opposite to the first surface 61, and a lateral side (not labeled) perpendicularly connected to the first surface 61 and the second surface 62. The first surface 61 and the second surface 62 in the present embodiment are in rectangular shapes (a square or a rectangle) of the same size, and the area of the second surface 62 is smaller than that of the top surface 41 of the sensor chip 4, but the disclosure is not limited thereto.

Furthermore, the transparent layer 6 is disposed above the sensor chip 4 by using the support 7, and the second surface 62 of the transparent layer 6 is substantially parallel to and faces the top surface 41 of the sensor chip 4. Moreover, the second surface 62 has a central region 621 facing the sensor chip 4, a ring-shaped supported region 622 enclosing the central region 621, and a ring-shaped fixed region 623 surrounding the supported region 622. The central region 621 of the second surface 62 aligns with the area the sensing region 411 of the sensor chip 4 orthogonally projects onto the second surface 62, but the disclosure is not limited thereto. The portion of the second surface 62 abutting upon the support 7 is just the supported region 622. The rest of the second surface 62 other than the central region 621 and the supported region 622 is just the fixed region 623.

In addition, the second surface 62 of the transparent layer 6 is preferably arranged close to each of the wires 5 but does not contact any one of the wires 5. A height of the apex of each wire 5 relative to the upper surface 11 of the substrate 1 is preferably smaller than a height of the second surface 62 of the transparent layer 6 relative to the upper surface 11 of the substrate 1, but the disclosure is not limited thereto.

The support 7 has a ring shape and is made of a glass mount epoxy (GME), but the disclosure is not limited thereto. A bottom end of the support 7 is disposed on the bearing region 413 of the top surface 41 of the sensor chip 4, and is located between the sensing region 411 and the connecting pads 4121. A top end of the support 7 abuts against the supported region 622 of the transparent layer 6. The support 7 neither contacts the central region 621 nor the fixed region 623. Accordingly, by means of the support 7 in the stack type sensor package structure 100, the second surface 62 of the transparent layer 6 is kept substantially parallel to and at a predetermined distance from the top surface 41 of the sensor chip 4.

The package compound 8 in the embodiment is a liquid compound, but the disclosure is not limited thereto. The package compound 8 is disposed on the upper surface 11 of the substrate 1 and covers the lateral side of the support 7, the lateral side and a part of the bearing plane 321 of the frame 3, the lateral side and the wire bonding region 412 of the sensor chip 4, and the lateral side and the fixed region 623 of the transparent layer 6. Moreover, the top surface 81 of the package compound 8 is an oblique surface or a curved surface, and an edge of the top surface 81 is connected to an edge of the transparent layer 6 (e.g., the edge of the first surface 61) so as to form an acute angle between the top surface 81 of the package compound 8 and the first surface 61 of the transparent layer 6. However, the disclosure is not limited thereto. In addition, each of the wires 5 and each of the solder pads 111 are embedded in the package compound 8.

As mentioned above, in the stack type sensor package structure 100 disclosed by the embodiment, the frame 3 is disposed on the substrate 1 so that the overall structural strength of the package structure is increased, and the sensor chip 4 can be disposed on the more stable frame 4 to thereby control levelness of the sensor chip 4. Furthermore, the wire bonding region 412 of the sensor chip 4 is solidly supported by the frame 3, thus the wires 5 can be effectively connected to the wire bonding region 412 of the sensor chip 4 during the wire bonding process, which avoids damaging other components.

In addition, the sensor chip 4 and the semiconductor chip 2 of the stack type sensor package structure 100 are separated from each other by the frame 3, the sensor chip 4 is less directly affected by heat generated from the semiconductor chip 2. Also, heat generated by the semiconductor chip 2 yet can dissipate through the substrate 1 and the solder balls 13, which effectively increases heat dissipating performance of the stack type sensor package structure 100.

### [Second Embodiment not making part of the invention]

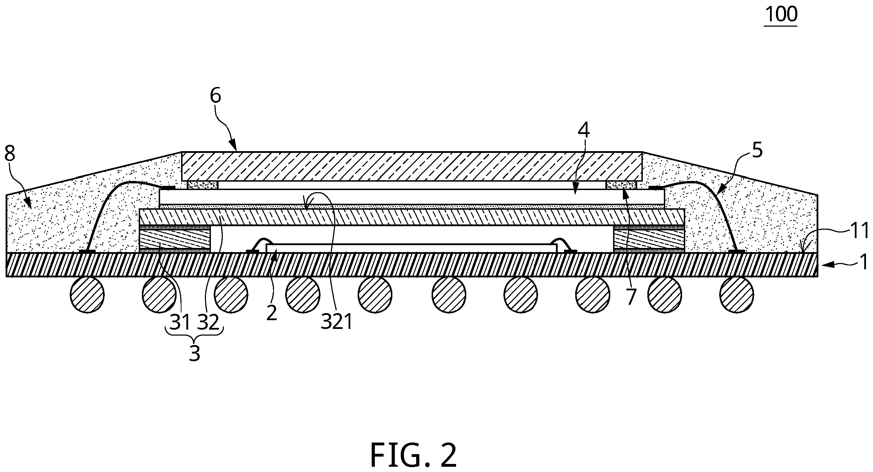

Reference is made to Fig. 2, which illustrates a second embodiment of the disclosure. The second embodiment is similar to the first embodiment. The common ground between the embodiments shall not be recited again. However, the major difference between the embodiments is in the structure of the frame 3, which is elaborated as follows.

In the present embodiment, the ring-shaped base 31 of the frame 3 is not integrally formed with the bearing plate 32 of the frame 3. For example, the ring-shaped base 31 is connected to a peripheral portion of the bearing plate 32 by an adhesive (not labeled), and the lateral side of the ring-shaped base 31 is flush with the lateral side of the bearing plate 32. The adhesive can be a UV curing adhesive, a thermal curing adhesive, an adhesive mixture including a UV curing adhesive and a thermal curing adhesive, or an attach film. However, the disclosure is not limited thereto.

Specifically, since the ring-shaped base 31 is not integrally formed with the bearing plate 32, the material of the ring-shaped base 31 can be the same as or different from that of the bearing plate 32. The ring-shaped base 31 or the bearing plate 32 may be made of a rigid material having a coefficient of thermal expansion (CTE) smaller than 10 ppm/°C, e.g., a glass material having a CTE of 7.2 ppm/°C, a silicon material having a CTE of 2.6 ppm/°C, a metallic material, or a ceramic material.

### [Third Embodiment not making part of the invention]

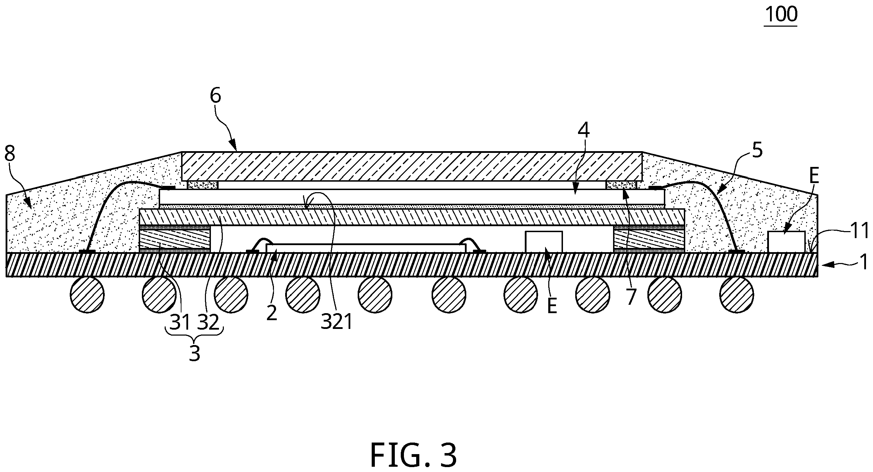

Reference is made to Fig. 3, which illustrates a third embodiment of the disclosure. The third embodiment is similar to the second embodiment. The common ground between the embodiments shall not be recited again. However, the difference between the embodiments is that the stack type sensor package structure 100 of the present embodiment further includes a plurality of passive electronic components E, and the difference is described as follows.

In the present embodiment, the passive electronic components E are mounted on the upper surface 11 of the substrate 1, and some of the passive electronic components E are disposed apart from the semiconductor chip 2 within the space enclosed by the substrate 1 and the frame 3, and the rest of the passive electronic components E are arranged outside the frame 3 and embedded in the package compound 8.

### [Fourth Embodiment not making part of the invention]

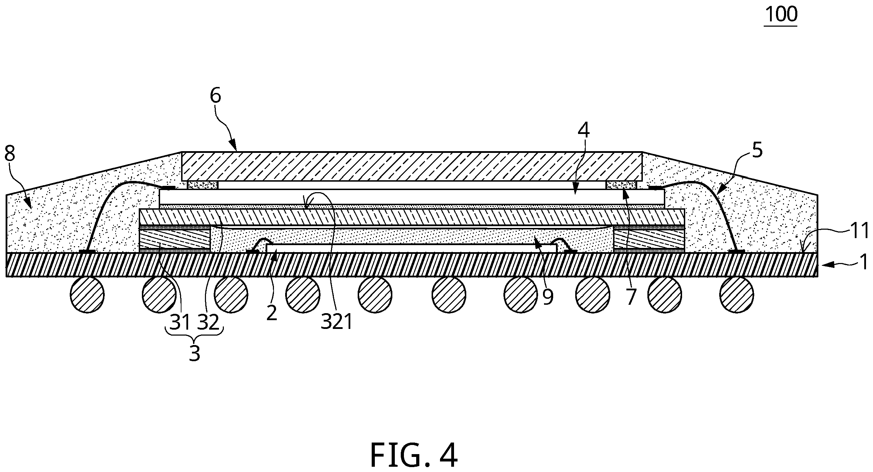

Reference is made to Fig. 4, which illustrates a fourth embodiment of the disclosure, similar to the second embodiment. The common ground between the embodiments shall not be recited again. However, the difference between the present embodiment and the second embodiment is that the stack type sensor package structure 100 of the present embodiment further includes a sealant 9, and the difference is recited as follows.

In the present embodiment, the space enclosed by the frame 3 and the substrate 1 is partially filled with the sealant 9, and the semiconductor chip 2 is embedded in the sealant 9. Moreover, when the ring-shaped base 31 is fixed on the upper surface 11 of the substrate 1 and is not connected to the bearing plate 32, the sealant 9 can fill the ring-shaped base 31 to embed the semiconductor chip 2 therein, and then the bearing plate 32 is fixed on the top end of the ring-shaped base 31.

### [Fifth Embodiment not making part of the invention]

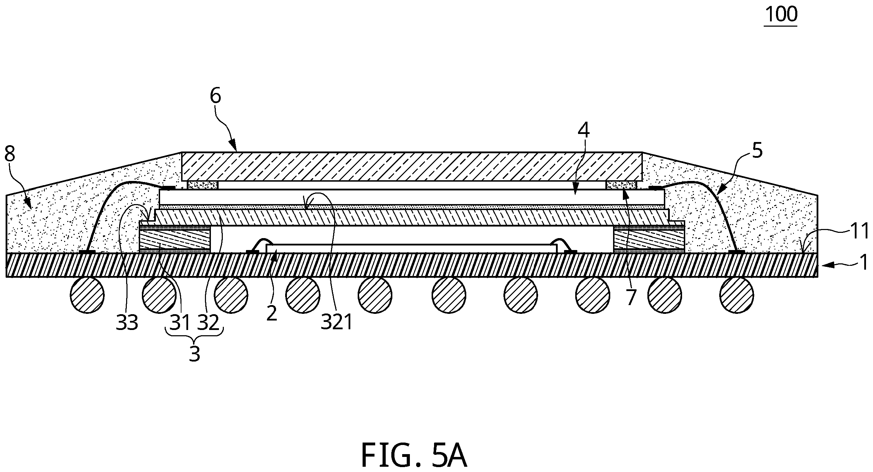

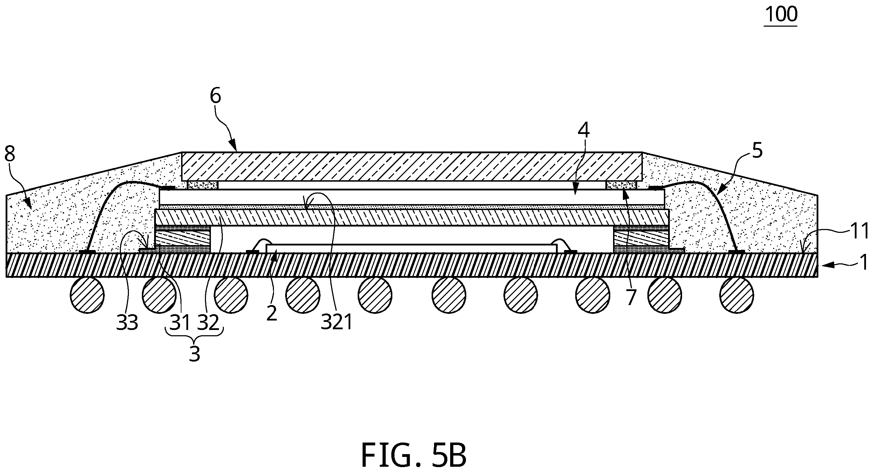

Reference is made to Figs. 5A and 5B, which illustrate a fifth embodiment of the disclosure, similar to the second embodiment. The description of the common ground between the two embodiments is skipped. The difference between the present embodiment and the second embodiment is in the structure of the frame 3, and the difference is described as follows.

In the present embodiment, the frame 3 is recessed at an edge of the bearing plane 231 to form a ring-shaped notch 33, and the ring-shaped notch 33 is outside the sensor chip 4. The depth of the notch 33 relative to the bearing plane 321 can be adjusted according to design requirements. For example, the notch 33 can be formed to extend into the bearing plate 32 only (as shown in Fig. 5A), or the notch 33 may be formed to further extend into the ring-shaped base 31 through the bearing plate 32 (as shown in Fig. 5B).

### [Sixth Embodiment not making part of the invention]

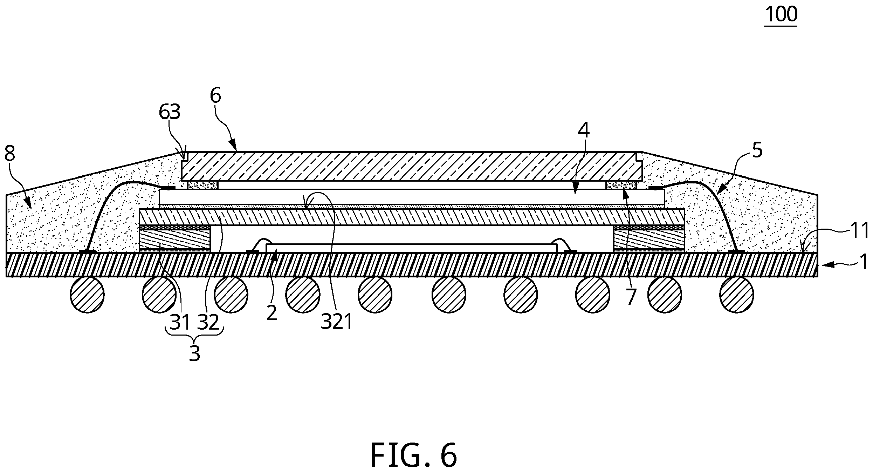

Reference is made to Fig. 6 illustrating a sixth embodiment of the disclosure similar to the second embodiment. The difference between the present embodiment and the second embodiment is in the structure of the transparent layer 6, which is described as follows.

In the present embodiment, the periphery of the top portion of the transparent layer 6 is formed with has a step portion 63 for the package compound 8 to be attached thereto. The specific structure of the step portion 63 can vary according to design requirements. For example, the step portion 63 can be a ring shape, an L shape, or an elongated strip shape.

### [Seventh Embodiment, according to the invention]

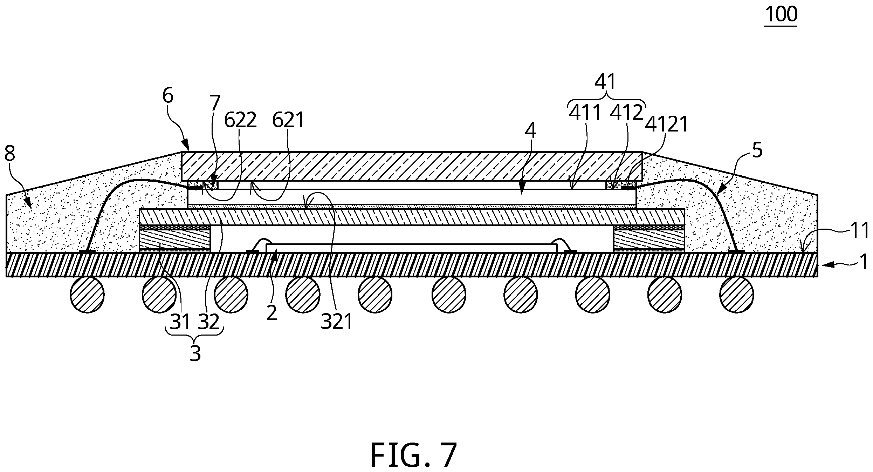

Fig. 7 illustrates a seventh embodiment, defining the invention, similar to the second embodiment. The difference between the present invention and the second embodiment is in the structure of the support 7, as follows.

In the invention, the top end of the support 7 abuts against the supported region 622 of the transparent layer 6, and the bottom end of the support 7 is disposed on the wire bonding region 412 of the top surface 41 of the sensor chip 4. The connecting pads 4121 and a part of each of the wires 5 are embedded in the support 7, and the rest part of each of the wires 5 is embedded in the package compound 8. From another perspective the top surface 41 of the sensor chip 4 only includes the sensing region 411 and the wire bonding region 412 surrounding the sensing region 411, but does not include the bearing region 413. In other words, the top surface of the sensor chip 4 may be deemed that the wire bonding region 412 coincides with the bearing region 413.

### [Eighth Embodiment, according to the invention]

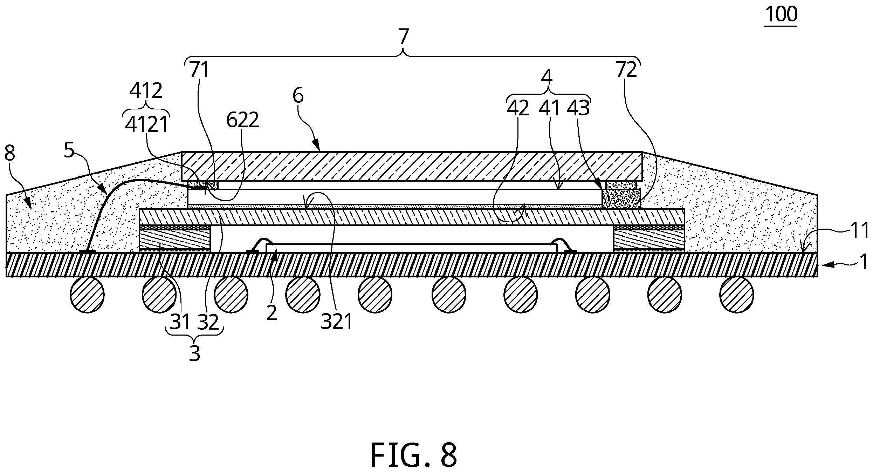

Fig. 8 illustrates an eighth embodiment, defining the invention, similar to the seventh embodiment. The difference between the present embodiment and the seventh embodiment is in the structure of the support 7, as follows.

In the present embodiment, the top end of the support 7 abuts against the supported region 622 of the transparent layer 6, a part of the bottom end of the support 7 is disposed on the top surface 41 of the sensor chip 4 and encompasses the connecting pads 4121 and a part of each of the wires 5, and the rest part of each of the wires 5 is embedded in the package compound 8.

Specifically, no connecting pad 4121 is disposed on an edge portion 43 of the sensor chip 4 (i.e., the right edge portion of the sensor chip 4 in Fig. 8). The support 7 includes a first supporting portion 71 and a second supporting portion 72. The top end of the first supporting portion 71 abuts against the supported region 622 of the transparent layer 6, and the bottom end of the first supporting portion 71 is disposed on the wire bonding region 412 of the top surface 41 of the sensor chip 4 and encompasses the connecting pads 4121 and the part of each of the wires 5. The top end of the second supporting portion 72 abuts against the supported region 622 of the transparent layer 6, the bottom end of the second supporting portion 72 is disposed on the bearing plane 321 and adjacent to the edge portion 43, and the second supporting portion 72 does not contact any one of the wires 5.

Moreover, the second supporting portion 72 in the present embodiment is described as a two layer structure formed with mutually stacked layers, but the disclosure is not limited thereto. For example, in other embodiments, the second supporting portion 72 can be an integrally formed one-piece structure.

Furthermore, the first supporting portion 71 and the second supporting portion 72 together can be an integral structure. For example, the bottom layer structure of the second supporting portion 72 is formed first, and the first supporting portion 71 and the upper layer of the second supporting portion 72, which connect with each other and both have a ring shape, are then formed. Wherein, the upper layer of the second supporting portion 72 is stacked on the lower layer of the second supporting portion 72. Or, the first supporting portion 71 and the second supporting portion 72 may be two separately formed components.

In addition, although in the present embodiment, the sensor chip 4 is exemplified as not having any connecting pad 4121 disposed on an edge portion 43 of the sensor chip 4, and the second supporting portion 72 is disposed with its position corresponding to the edge portion 43, the disclosure is not limited thereto. For example, in other embodiments, the sensor chip 4 may include at least two edge portions 43 on which there is no connecting pad 4121 disposed.

### [Ninth Embodiment, according to the invention]

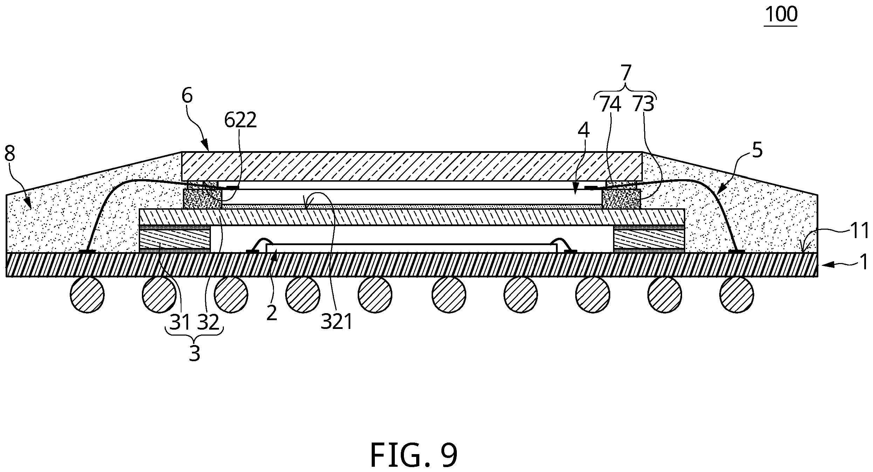

Fig. 9 illustrates a ninth embodiment, defining the invention, similar to the eighth embodiment. The difference between the present embodiment and the eighth embodiment is in the structure of the support 7, as follows.

In the present embodiment, the support 7 is disposed on the bearing plane 321 of the frame 3 and adjacent to the lateral side of the sensor chip 4. A part of each of the wires 5 is embedded in the support 7, and the other part of each of the wires 5 is embedded in the package compound 8. Specifically, the support 7 includes a supporting layer 73 and a connecting layer 74. The supporting layer 73 is disposed on the bearing plane 321 of the frame 3 and adjacent to the lateral side of the sensor chip 4, and the supporting layer 73 does not contact any one of the wires 5. The connecting layer 74 is disposed on the supporting layer 73, a top end of the connecting layer 74 abuts against the supported region 622 of the transparent layer 6, and a part of each of the wires 5 is embedded in the connecting layer 74. A height of the supporting layer 73 relative to the bearing plane 321 is substantially equal to a height of the sensor chip 4 relative to the bearing plane 321. However, the disclosure is not limited thereto.

In addition, the supporting layer 73 and the connecting layer 74 of the support 7 in the present embodiment are two independent components, but the disclosure is not limited thereto. For example, in other embodiments, the supporting layer 73 and the connecting layer 74 together may be an integrally formed one-piece structure.

Moreover, the supporting layer 73 of the support 7 in the present embodiment is connected to the lateral side of the sensor chip 4, but in other embodiments, a gap can be formed between the support 7 and the lateral side of the sensor chip 4.

### [Tenth Embodiment, according to the invention]

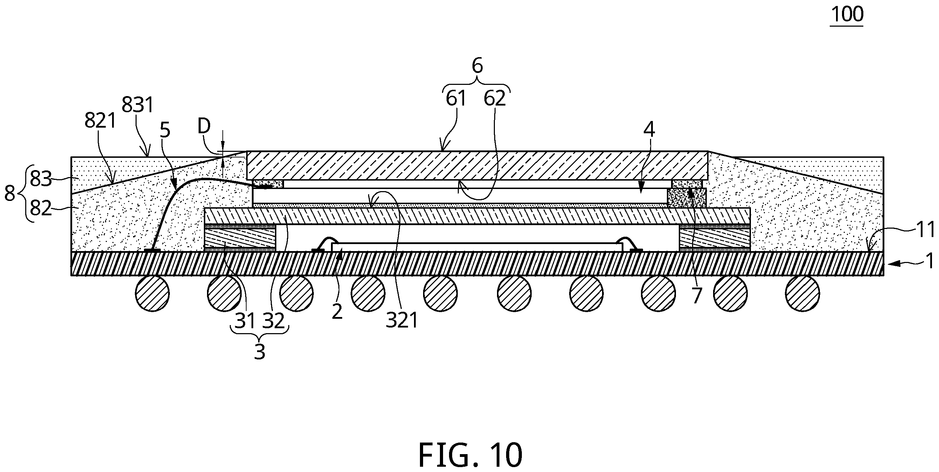

Fig. 10 illustrates a tenth embodiment, defining the invention, similar to the eighth embodiment. The difference between the present embodiment and the eighth embodiment is in the structure of the package compound 8, as follows.

In the present embodiment, the package compound 8 includes a liquid compound 82 and a molding compound 83. The package compound 8 has been recited in the above embodiments and shall not be described here again. Moreover, the molding compound 83 is formed on the top surface 821 of the liquid compound 82, and a top surface 831 of the molding compound 83 is parallel to the first surface 61 of the transparent layer 6. The top surface 831 of the molding compound 83 is lower than the first surface 61 of the transparent layer 6 by an overflow preventing distance D which is about 50µm to 100µm.

### [Eleventh Embodiment, according to the invention]

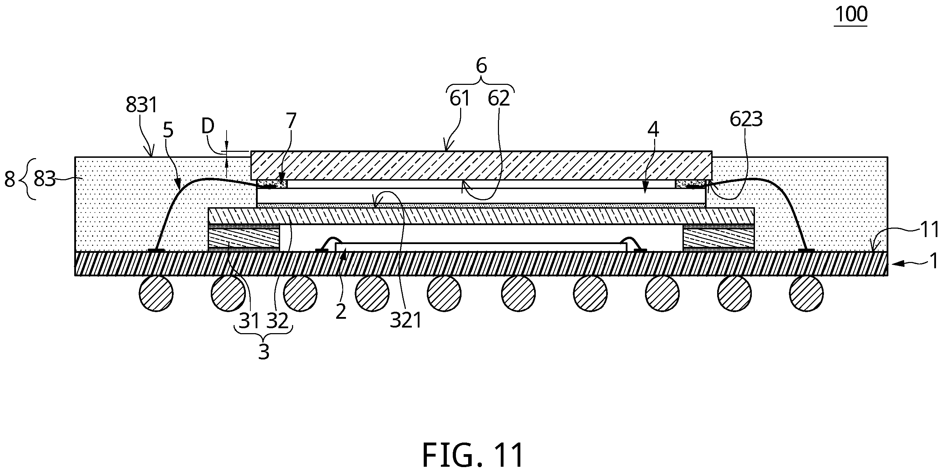

Fig. 11 illustrates an eleventh embodiment, defining the invention, similar to the seventh embodiment. The difference between the present embodiment and the seventh embodiment is in the structure of the package compound 8, as follows.

In the present embodiment, the package compound 8 is a molding compound 83 disposed on the upper surface 11 of the substrate 1, and covers the lateral side of the support 7, the lateral side of the frame 3 and a part of the bearing plane 321 thereof, the lateral side of the sensor chip 4, and the fixed region 623 and a part of the lateral side of the transparent layer 6. Moreover, a top surface 831 of the package compound 8 (i.e., the molding compound 83) is planar and lower than the first surface 61 of the transparent layer 6 by an overflow preventing distance D which is about 50µm to 100µm.

### [Twelfth Embodiment not making part of the invention]

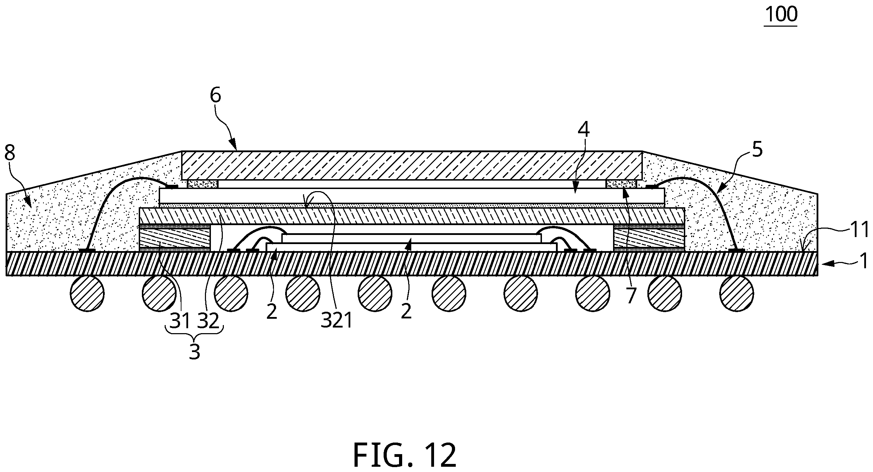

Fig. 12 illustrates a twelfth embodiment not making part of the invention, similar to the second embodiment. The difference between the present embodiment and the second embodiment is that the stack type sensor package structure 100 of the present embodiment includes a plurality of semiconductor chips 2, as follows.

In the present embodiment, the semiconductor chips 2 are sequentially stacked on the upper surface 11 of the substrate 1, and each of the semiconductor chips 2 is connected to the upper surface 11 of the substrate 1 by wire bonding, thereby establishing an electrical connection between each of the semiconductor chips 2 and the substrate 1.

### [Thirteenth Embodiment not making part of the invention]

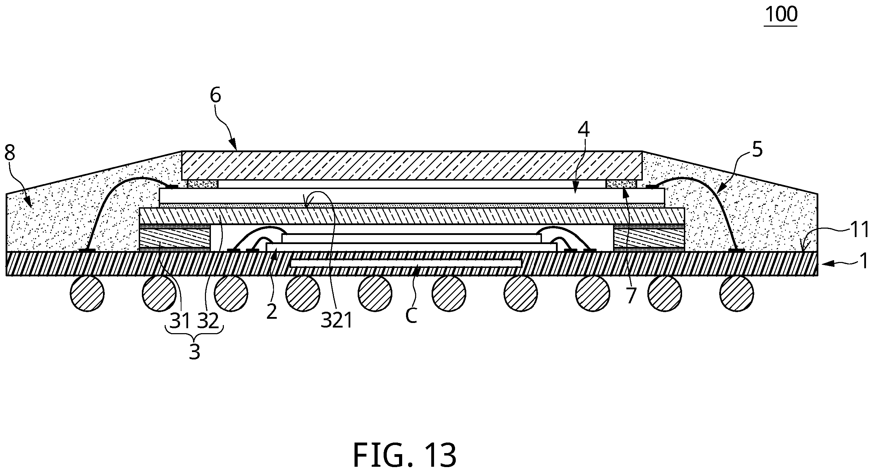

Fig. 13 illustrates a thirteenth embodiment not making part of the invention, similar to the twelfth embodiment. The difference between the present embodiment and the twelfth embodiment is that the stack type sensor package structure 100 of the present embodiment further includes an embedded chip C, as follows.

In the present embodiment, the embedded chip C is embedded in the substrate 1. In other embodiments, the stack type sensor package structure 100 may include a plurality of embedded chips C embedded in the substrate 1.

### [Fourteenth Embodiment not making part of the invention]

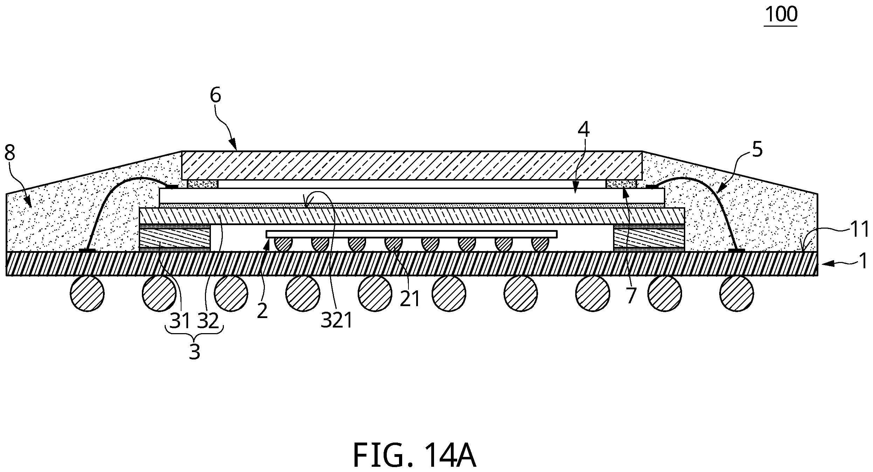

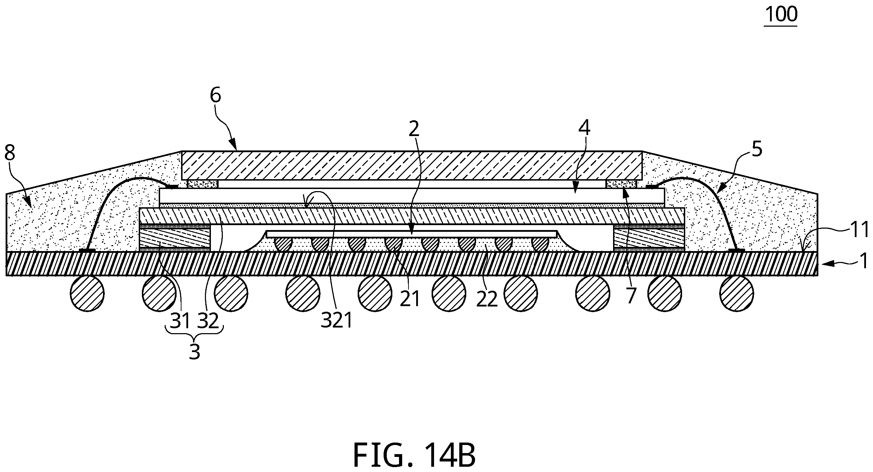

Figs. 14A and 14B illustrate a fourteenth not making part of the invention, similar to the seventh embodiment. The difference between the present embodiment and the seventh embodiment is the way the semiconductor chip 2 is bonded to the substrate 1, as follows.

In the present embodiment, wire bonding is not implemented for the electrical connection between the semiconductor chip 2 and the substrate 1. Specifically, the semiconductor chip 2 is soldered onto the substrate 1 through a plurality of metal balls 21, thereby electrically connecting the semiconductor chip 2 and the substrate 1. Moreover, as show in Fig. 14B, an underfill agent 22 is filled between the semiconductor chip 2 and the substrate 1, and the metal balls 21 are embedded in the underfill agent 22.

### [Fifteenth Embodiment not making part of the invention]

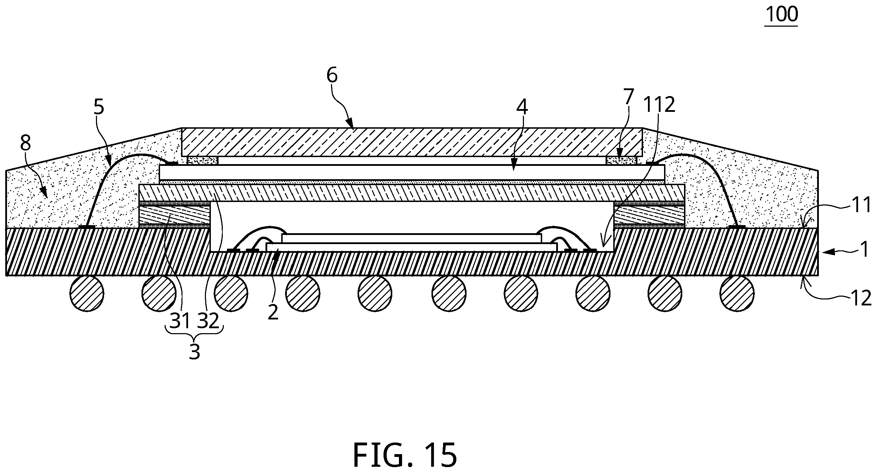

Fig. 15 illustrates a fifteenth embodiment not making part of the invention, similar to the twelfth embodiment. The difference between the present embodiment and the twelfth embodiment is in structure of the substrate 1, as follows.

In the present embodiment, the substrate 1 is recessed from the upper surface 11 thereof to form an accommodating slot 112, and the semiconductor chips 2 are arranged in the accommodating slot 112. Each of the semiconductor chips 2 is connected to the bottom of the accommodating slot 112 by wire bonding, thereby electrically connecting each of the semiconductor chips 2 with the substrate 1.

### [Sixteenth Embodiment not making part of the invention]

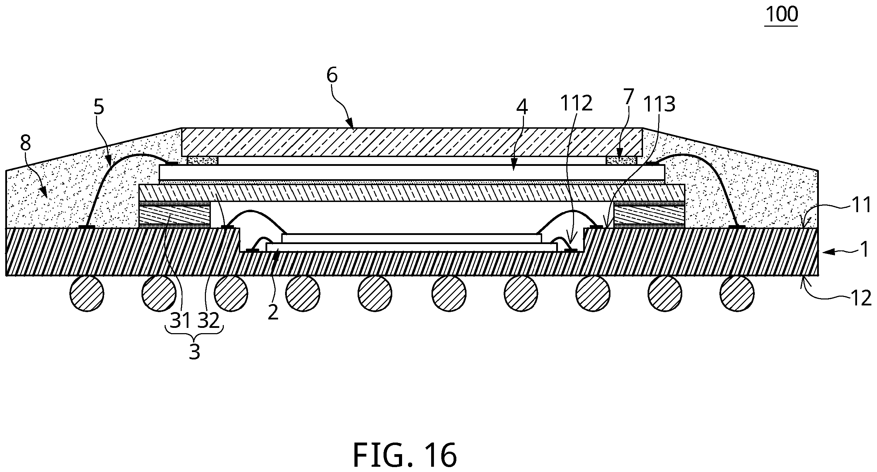

Fig. 16 illustrates a sixteenth embodiment not making part of the invention, similar to the fifteenth embodiment. The difference between the present embodiment and the fifteenth embodiment is in the structure of the substrate 1, as follows.

In the present embodiment, the upper surface 11 of the substrate 1 has a wire bonding region 113 arranged between the frame 3 and the accommodating slot 112. At least one of the semiconductor chips 2 (i.e., the upper semiconductor chip 2 as shown in Fig. 16) is connected to the wire bonding region 113 of the substrate 1 by wire bonding, and the other semiconductor chip 2 (i.e., the lower semiconductor chip 2 as shown in Fig. 16) is connected to the bottom of the accommodating slot 112 of the substrate 1 by wire bonding, thereby electrically connecting each of the semiconductor chips 2 with the substrate 1.

### [Seventeenth Embodiment not making part of the invention]

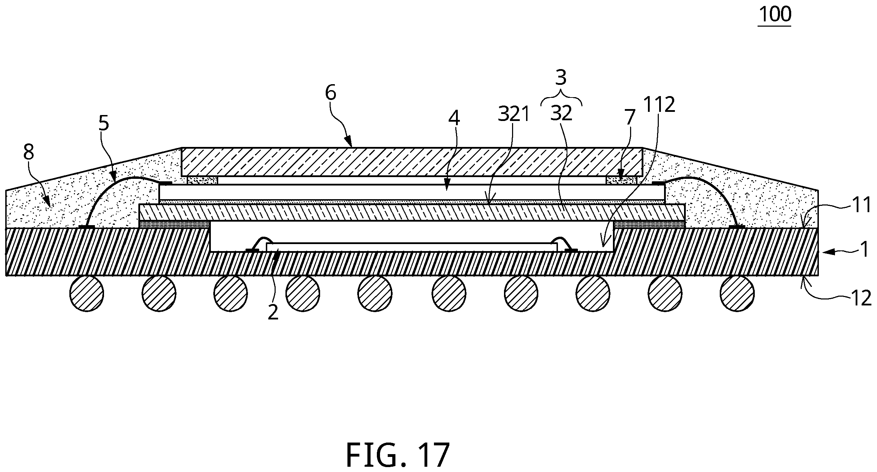

Fig. 17 illustrates a seventeenth embodiment not making part of the invention, similar to the fifteenth embodiment. The difference between the present embodiment and the fifteenth embodiment is in the structure of the frame 3, and the difference is disclosed as follows.

In the present embodiment, the frame 3 is limited to a bearing plate 32 adhered to the upper surface 11 of the substrate 1, and an outer surface of the bearing plate 32 is defined as the bearing plane 321. The periphery of the bearing plate 32 can be connected to the upper surface 11 of the substrate 1 by an adhesive (not labeled), thereby sealing the accommodating slot 112. The adhesive can be a UV curing adhesive, a thermal curing adhesive, an adhesive mixture including a UV curing adhesive and a thermal curing adhesive, or an attach film, but the disclosure is not limited thereto.

### [Eighteenth Embodiment not making part of the invention]

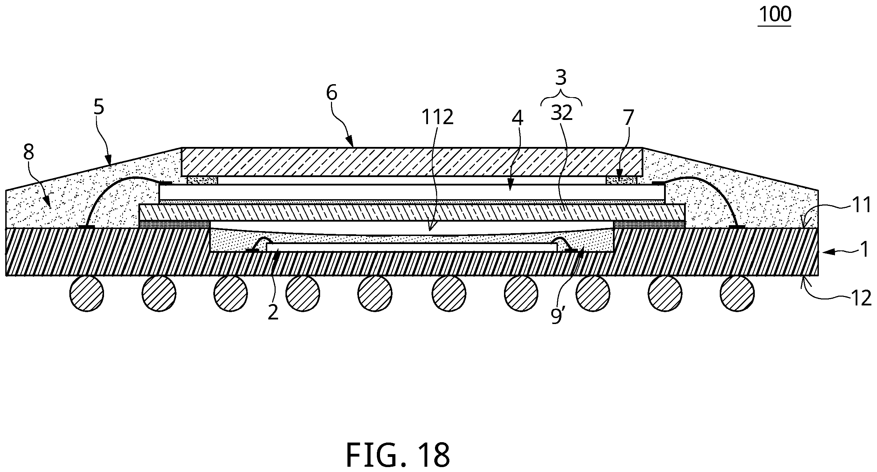

Fig. 18 illustrates an eighteenth embodiment not making part of the invention, similar to the seventeenth embodiment. The difference between the present embodiment and the seventeenth embodiment is that the stack type sensor package structure 100 of the present embodiment further includes a sealant 9', as follows.

In the present embodiment, the accommodating slot 112 is filled with the sealant 9', wherein the semiconductor chip 2 is embedded in the sealant 9'.

### [Nineteenth Embodiment not making part of the invention]

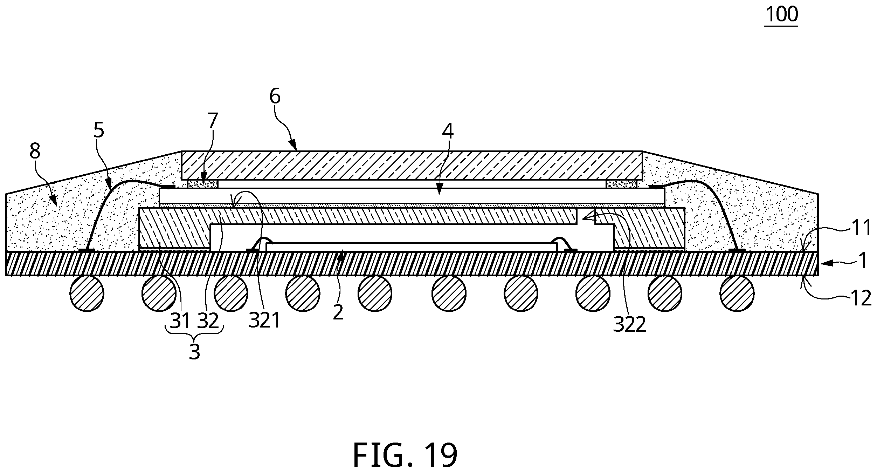

Fig. 19 illustrates a nineteenth embodiment not making part of the invention, similar to the first embodiment. The difference between the present embodiment and the first embodiment is in the structure of the frame 3, as follows.

In the present embodiment, the bearing plate 32 of the frame 3 has a through hole 322, and the sensor chip 4 covers the through hole 322. The through hole 322 in the present embodiment is not located directly above the semiconductor chip 2, but the specific position of the through hole 322 formed in the frame 3 in the disclosure is not limited to the present embodiment. Accordingly, when the adhesive (not labeled) between the frame 3 and the substrate 1 is baked so as to fix the frame 3 onto the upper surface 11 of the substrate 1, air in the space between the frame 3 and the substrate 1 expands as it is heated and may exhaust through the through hole 322, thereby maintaining levelness of the bearing plane 321 of the frame 3.

### [Twentieth Embodiment, according to the invention]

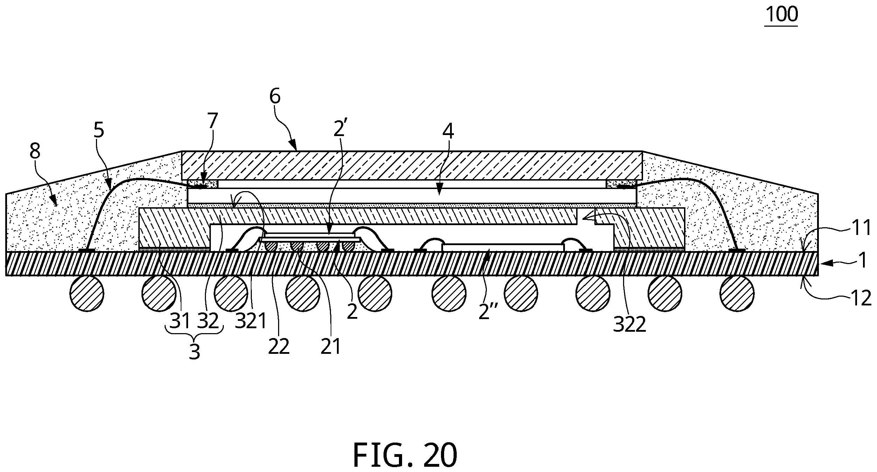

Fig. 20, which illustrates a twentieth embodiment of the disclosure, similar to the nineteenth embodiment. The difference between the present embodiment and the nineteenth embodiment is that the stack type sensor package structure 100 of the present embodiment includes at least three semiconductor chips 2, 2', 2", as follows.

In the present embodiment, the three semiconductor chips 2, 2', 2" can be fixed in different manners and are respectively named as the first semiconductor chip 2, the second semiconductor chip 2', and the third semiconductor chip 2" for distinguishing among them. However, the terms "first", "second", and "third" do not have any technical meaning.

The first semiconductor chip 2 is soldered on the upper surface 11 of the substrate 1 through a plurality of metal balls 21, thereby electrically connecting the first semiconductor chip 2 and the substrate 1. Moreover, an underfill agent 22 is filled between the first semiconductor chip 2 and the substrate 1, and the metal balls 21 are embedded in the underfill agent 22.

The second semiconductor chip 2' is stacked on the first semiconductor chip 2, and is electrically connected to the upper surface 11 of the substrate 1 by wire bonding, thereby electrically connecting the second semiconductor chip 2' and the substrate 1.

The third semiconductor chip 2" is disposed on the upper surface 11 of the substrate 1 and is located beside the pile of the first and second semiconductor chips 2, 2'. The third semiconductor chip 2" is electrically connected to the upper surface 11 of the substrate 1 by wire bonding, thereby establishing an electrical connection between the third semiconductor chip 2" and the substrate 1.

It should be noted that the type of the first semiconductor chip 2, the second semiconductor chip 2', or the third semiconductor chip 2" can be determined according to design requirements. For example, the semiconductor chips 2, 2', 2" can be an image signal processor (ISP), a flash memory, or a micro controller.

The descriptions illustrated *supra* set forth simply the preferred embodiments of the disclosure; however, the characteristics of the disclosure are by no means restricted thereto. All changes, alterations, or modifications conveniently considered by those skilled in the art are deemed to be encompassed within the scope of the disclosure delineated by the following claims.

## Claims

1. A stack type sensor package structure, comprising:
a substrate (1) having an upper surface (11) and a lower surface (12) opposite to the upper surface (11), wherein the substrate (1) includes a plurality of solder pads (111) arranged on the upper surface (11);
at least one semiconductor chip (2) mounted on the substrate (1);
a frame (3) fixed on the upper surface (11) of the substrate (1) and surrounded by the solder pads (111), wherein the at least one semiconductor chip (2) is in a space defined by the frame (3) and the substrate (1) and does not contact the frame (3), and the frame (3) has a bearing plane (321) above the at least one semiconductor chip (2);
a sensor chip (4) having a top surface (41) and a bottom surface (42) opposite to the top surface (41), the sensor chip (4) including a plurality of connecting pads (4121) arranged on the top surface (41) thereof, wherein a size of the sensor chip (4) is larger than that of the at least one semiconductor chip (2), and the bottom surface (42) of the sensor chip (4) is fixed on the bearing plane (321);
a plurality of wires (5) each having a first end and a second end opposite to the first end, wherein the first ends of the wires (5) are respectively connected to the solder pads (111), and the second ends of the wires (5) are respectively connected to the connecting pads (4121);
a transparent layer (6) having a first surface (61) and a second surface (62) opposite to the first surface (61), wherein the second surface (62) has a central region (621) and a ring-shaped supported region (622) encircling the central region (621);
a support (7) having a ring-shaped structure;
**characterized in that**
said support (7) is disposed on at least one of the top surface (41) of the sensor chip (4) and the bearing surface of the frame (3), wherein a top end of the support (7) abuts against the supported region (622) of the transparent layer (6); and
a package compound (8) disposed on the upper surface (11) of the substrate (1) and covering a lateral side of the frame (3), at least part of a lateral side of the transparent layer (6), and a lateral side of the support (7), wherein at least part of each of the wires (5) is embedded in the package compound (8),
wherein at least part of the support (7) is disposed on the top surface (41) of the sensor chip (4), and covers the connecting pads (4121) and a part of each of the wires (5).

2. The stack type sensor package structure as claimed in claim 1, wherein the frame (3) is recessed at an edge of the bearing plane (321) to form a ring-shaped notch (33), and the ring-shaped notch (33) is outside the sensor chip (4).

3. The stack type sensor package structure as claimed in claim 1, wherein an edge portion (43) of the sensor chip (4) does not include any connecting pads (4121), and the support (7) includes:
a first supporting portion (71) disposed on the top surface (41) of the sensor chip (4) and covering the connecting pads (4121) and a part of each of the wires (5); and
a second supporting portion (72) disposed on the bearing plane (321) and arranged adjacent to the edge portion (43), wherein the second supporting portion (72) does not contact any one of the wires (5),
wherein a top end of the first supporting portion (71) and a top end of the second supporting portion (72) both abut against the supported region (622) of the transparent layer (6).

4. The stack type sensor package structure as claimed in claim 1, wherein the top surface (41) of the sensor chip (4) has a sensing region (411), the connecting pads (4121) are arranged at a periphery of the sensing region (411), and the support (7) is disposed on the top surface (41) of the sensor chip (4) and located between the sensing region (411) and the connecting pads (4121).

5. The stack type sensor package structure as claimed in claim 1, wherein the support (7) is disposed on the bearing plane (321) of the frame (3) and located at a periphery of the sensor chip (4), and the support (7) encompasses a part of each of the wires (5).

6. The stack type sensor package structure as claimed in claim 5, wherein the support (7) includes:
a supporting layer (73) disposed on the bearing plane (321) and located at the periphery of the sensor chip (4); and
a connecting layer (74) disposed on the supporting layer (73), wherein a top end of the connecting layer (74) abuts against the supported region (622) of the transparent layer (6).

7. The stack type sensor package structure as claimed in claim 6, wherein a height of the supporting layer (73) relative to the bearing plane (321) is substantially equal to a height of the top surface (41) of the sensor chip (4) relative to the bearing plane (321), the part of each of the wires (5) is embedded in the connecting layer, and the supporting layer (73) does not contact any one of the wires (5).

8. The stack type sensor package structure as claimed in claim 1, wherein the package compound (8) is a molding compound (83), the package compound (8) having a planar top surface (41) lower than the first surface (61) of the transparent layer (6) by an overflow preventing distance (D) about 50µm to 100µm.

9. The stack type sensor package structure as claimed in claim 1, wherein the package compound (8) includes:
a liquid compound (82) covering the lateral side of the frame (3), the lateral side of the transparent layer (6), and the lateral side of the support (7), wherein the liquid compound (82) has an oblique top surface (821), and an edge of the oblique top surface (821) is connected to an edge of the transparent layer (6); and
a molding compound (83) formed on the oblique top surface (821) of the liquid compound (82), the molding compound (83) has a top surface (831) parallel to the first surface (61) of the transparent layer (6), and the top surface (831) of the molding compound (83) is lower than the first surface (61) of the transparent layer (6) by an overflow preventing distance (D) about 50µm to 100µm.

10. The stack type sensor package structure as claimed in claim 1, further comprising at least one embedded chip (C) embedded in the substrate (1).

11. The stack type sensor package structure as claimed in any one of claims 1 to 10, wherein the frame (3) includes:
a ring-shaped base (31) fixed on the substrate (1); and
a bearing plate (32) connected to the ring-shaped base (31), wherein an outer surface of the bearing plate (32) is defined as the bearing plane (321).

12. The stack type sensor package structure as claimed in claim 11, wherein the bearing plate (32) has a through hole (322), and the sensor chip (4) shields the through hole (322).

13. The stack type sensor package structure as claimed in any one of claims 1 to 10, wherein the substrate (1) is recessed from the upper surface (11) thereof to form an accommodating slot (112), and the at least one semiconductor chip (2) is arranged in the accommodating slot (112).

14. The stack type sensor package structure as claimed in claim 13, wherein the frame (3) is a bearing plate (32) adhered to the upper surface (11) of the substrate (1), and an outer surface of the bearing plate (32) is defined as the bearing plane (321).

15. The stack type sensor package structure as claimed in claim 13, wherein multiple semiconductor chips (2) are included in the stack type sensor package structure (100), and the semiconductor chips (2) are electrically connected to the substrate (1) by wire bonding.

16. The stack type sensor package structure as claimed in claim 15, wherein the upper surface (11) of the substrate (1) has a wire bonding region (113) arranged between the frame (3) and the accommodating slot (112), and at least one of the semiconductor chips (2) is electrically connected to the wire bonding region (113) of the substrate (1) by wire bonding.

## Patentansprüche

1. Stapeltyp-Sensorpaketstruktur, aufweisend:
ein Substrat (1), welches eine obere Fläche (11) und eine untere Fläche (12) hat, welche zu der oberen Fläche (11) entgegengesetzt ist, wobei das Substrat (1) eine Mehrzahl von Lötpads (111) aufweist, welche an der oberen Fläche (11) angeordnet sind,
mindestens einen Halbleiterchip (2), welcher an dem Substrat (1) montiert ist,
einen Rahmen (3), welcher an der oberen Fläche (11) des Substrats (1) fixiert ist und von den Lötpads (111) umgeben ist, wobei der mindestens eine Halbleiterchip (2) sich in einem Raum befindet, welcher mittels des Rahmens (3) und des Substrats (1) definiert ist, und den Rahmen (3) nicht berührt, und wobei der Rahmen (3) eine Lagerebene (321) oberhalb von dem mindestens einen Halbleiterchip (2) hat,
einen Sensorchip (4), welcher eine obere Fläche (41) und eine untere Fläche (42) hat, welche zu der oberen Fläche (41) entgegengesetzt ist, wobei der Sensorchip (4) eine Mehrzahl von Verbindungspads (4121) aufweist, welche an der oberen Fläche (41) davon angeordnet sind, wobei eine Größe des Sensorchips (4) größer ist als die des mindestens einen Halbleiterchips (2), und die untere Fläche (42) des Sensorchips (4) an der Lagerebene (321) fixiert ist,
eine Mehrzahl von Drähten (5), wobei jeder ein erstes Ende und ein zweites Ende hat, welches zu dem ersten Ende entgegengesetzt ist, wobei die ersten Enden der Drähte (5) in jeweils zugeordneter Weise mit den Lötpads (111) verbunden sind, und die zweiten Enden der Drähte (5) in jeweils zugeordneter Weise mit den Verbindungspads (4121) verbunden sind,
eine transparente Schicht (6), welche eine erste Fläche (61) und eine zweite Fläche (62) hat, welche zu der ersten Fläche (61) entgegengesetzt ist, wobei die zweite Fläche (62) einen Mittelbereich (621) und einen ringförmigen gelagerten Bereich (622) hat, welcher den Mittelbereich (621) umringt,
ein Lager (7), welches eine ringförmige Struktur hat,
**dadurch gekennzeichnet, dass**
besagtes Lager (7) an mindestens einer von der oberen Fläche (41) des Sensorchips (4) und der Lagerfläche des Rahmens (3) angeordnet ist, wobei ein oberes Ende des Lagers (7) an dem gelagerten Bereich (622) der transparenten Schicht (6) anliegt, und
ein Paket-Verbundwerkstoff (8), welcher an der oberen Fläche (11) des Substrats (1) angeordnet ist und eine Lateralseite des Rahmens (3), zumindest einen Teil einer Lateralseite der transparenten Schicht (6) und eine Lateralseite des Lagers (7) bedeckt, wobei zumindest ein Teil von jedem der Drähte (5) in dem Paket-Verbundwerkstoff (8) eingebettet ist,
wobei zumindest ein Teil des Lagers (7) an der oberen Fläche (41) des Sensorchips (4) angeordnet ist und die Verbindungspads (4121) und einen Teil von jedem der Drähte (5) bedeckt.

2. Stapeltyp-Sensorpaketstruktur gemäß Anspruch 1, wobei der Rahmen (3) an einem Rand der Lagerebene (321) ausgespart ist, um eine ringförmige Kerbe (33) zu bilden, und die ringförmige Kerbe (33) sich außerhalb von dem Sensorchip (4) befindet.

3. Stapeltyp-Sensorpaketstruktur gemäß Anspruch 1, wobei ein Randabschnitt (43) des Sensorchips (4) keine Verbindungspads (4121) aufweist, und das Lager (7) aufweist:
einen ersten Lagerabschnitt (71), welcher an der oberen Fläche (41) des Sensorchips (4) angeordnet ist und die Verbindungspads (4121) und einen Teil von jedem der Drähte (5) bedeckt, und
einen zweiten Lagerabschnitt (72), welcher an der Lagerebene (321) angeordnet ist und benachbart zu dem Randabschnitt (43) angeordnet ist, wobei der zweite Lagerabschnitt (72) keinen von den Drähten (5) berührt,
wobei sowohl ein oberes Ende des ersten Lagerabschnitts (71) als auch ein oberes Ende des zweiten Lagerabschnitts (72) an dem gelagerten Bereich (622) der transparenten Schicht (6) anliegt.

4. Stapeltyp-Sensorpaketstruktur gemäß Anspruch 1, wobei die obere Fläche (41) des Sensorchips (4) einen Erfassungsbereich (411) hat, die Verbindungspads (4121) an einem Peripheriebereich des Abtastbereichs (411) angeordnet sind, und das Lager (7) an der oberen Fläche (41) des Sensorchips (4) angeordnet ist und sich zwischen dem Erfassungsbereich (411) und den Verbindungspads (4121) befindet.

5. Stapeltyp-Sensorpaketstruktur gemäß Anspruch 1, wobei das Lager (7) an der Lagerebene (321) des Rahmens (3) angeordnet ist und sich an einem Peripheriebereich des Sensorchips (4) befindet, und das Lager (7) einen Teil von jedem der Drähte (5) umgibt.

6. Stapeltyp-Sensorpaketstruktur gemäß Anspruch 5, wobei das Lager (7) aufweist:
eine Lagerschicht (73), welche an der Lagerebene (321) angeordnet ist und sich an dem Peripheriebereich des Sensorchips (4) befindet, und
eine Verbindungsschicht (74), welche an der Lagerschicht (73) angeordnet ist, wobei ein oberes Ende der Verbindungsschicht (74) an dem gelagerten Bereich (622) der transparenten Schicht (6) anliegt.

7. Stapeltyp-Sensorpaketstruktur gemäß Anspruch 6, wobei eine Höhe der Lagerschicht (73) relativ zu der Lagerebene (321) im Wesentlichen gleich einer Höhe der oberen Fläche (41) des Sensorchips (4) relativ zu der Lagerebene (321) ist, der Teil von jedem der Drähte (5) in der Verbindungsschicht eingebettet ist und die Lagerschicht (73) keinen von den Drähten (5) berührt.

8. Stapeltyp-Sensorpaketstruktur gemäß Anspruch 1, wobei der Paket-Verbundwerkstoff (8) eine Formverbundmasse (83) ist, der Paket-Verbundwerkstoff (8) eine ebene obere Fläche (41) hat, welche um einen Überlauf-Verhinderung-Abstand (D) von etwa 50 µm bis 100 µm niedriger als die erste Fläche (61) der transparenten Schicht (6) ist.

9. Stapeltyp-Sensorpaketstruktur gemäß Anspruch 1, wobei der Paket-Verbundwerkstoff (8) aufweist:
einen Flüssigverbundwerkstoff (82), welcher die Lateralseite des Rahmens (3), die Lateralseite der transparenten Schicht (6) und die Lateralseite des Lagers (7) bedeckt, wobei der Flüssigverbundwerkstoff (82) eine schräge obere Fläche (821) hat, und ein Rand der schrägen oberen Fläche (821) mit einem Rand der transparenten Schicht (6) verbunden ist, und
eine Formverbundmasse (83), welche an der schrägen oberen Fläche (821) des Flüssigverbundwerkstoffs (82) gebildet ist, wobei die Formverbundmasse (83) eine obere Fläche (831) hat, welche parallel zu der ersten Fläche (61) der transparenten Schicht (6) ist, und die obere Fläche (831) der Formverbundmasse (83) um einen Überlauf-Verhinderung-Abstand (D) von ungefähr 50 µm bis 100 µm niedriger als die erste Fläche (61) der transparenten Schicht (6) ist.

10. Stapeltyp-Sensorpaketstruktur gemäß Anspruch 1, welche ferner mindestens einen eingebetteten Chip (C) aufweist, welcher in dem Substrat (1) eingebettet ist.

11. Stapeltyp-Sensorpaketstruktur gemäß einem von den Ansprüchen 1 bis 10, wobei der Rahmen (3) aufweist:
eine ringförmige Basis (31), welche an dem Substrat (1) fixiert ist, und
eine Lagerplatte (32), welche mit der ringförmigen Basis (31) verbunden ist, wobei eine Außenfläche der Lagerplatte (32) als die Lagerebene (321) definiert ist.

12. Stapeltyp-Sensorpaketstruktur gemäß Anspruch 11, wobei die Lagerplatte (32) ein Durchgangsloch (322) hat, und der Sensorchip (4) das Durchgangsloch (322) abschirmt.

13. Stapeltyp-Sensorpaketstruktur gemäß einem von den Ansprüchen 1 bis 10, wobei das Substrat (1) von der oberen Fläche (11) davon aus ausgespart ist, um einen Aufnahmeschlitz (112) zu bilden, und der mindestens eine Halbleiterchip (2) in dem Aufnahmeschlitz (112) angeordnet ist.

14. Stapeltyp-Sensorpaketstruktur gemäß Anspruch 13, wobei der Rahmen (3) eine Lagerplatte (32) ist, welche an der oberen Fläche (11) des Substrats (1) anhaftet, und eine Außenfläche der Lagerplatte (32) als die Lagerebene (321) definiert ist.

15. Stapeltyp-Sensorpaketstruktur gemäß Anspruch 13, wobei mehrere Halbleiterchips (2) von der Stapeltyp-Sensorpaketstruktur (100) aufgewiesen werden, und die Halbleiterchips (2) mit dem Substrat (1) mittels Drahtbondens elektrisch verbunden sind.

16. Stapeltyp-Sensorpaketstruktur gemäß Anspruch 15, wobei die obere Fläche (11) des Substrats (1) einen Drahtbondbereich (113) aufweist, welcher zwischen dem Rahmen (3) und dem Aufnahmeschlitz (112) angeordnet ist, und mindestens einer von den Halbleiterchips (2) mit dem Drahtbondbereich (113) des Substrats (1) mittels Drahtbondens elektrisch verbunden ist.

## Revendications

1. Structure de boîtier de capteur du type à empilement, comprenant :
un substrat (1) qui présente une surface supérieure (11) et une surface inférieure (12) opposée à la surface supérieure (11), dans laquelle le substrat (1) comprend une pluralité de plages de soudure (111) agencées sur la surface supérieure (11) ;
au moins une puce de semi-conducteur (2) montée sur le substrat (1) ;
un cadre (3) fixé sur la surface supérieure (11) du substrat (1) et entouré par les plages de soudure (111), dans laquelle l'au moins une puce de semi-conducteur (2) se trouve dans un espace défini par le cadre (3) et le substrat (1), et n'entre pas en contact avec le cadre (3), et le cadre (3) présente un plan porteur (321) au-dessus de l'au moins une puce de semi-conducteur (2) ;
une puce de capteur (4) qui présente une surface supérieure (41) et une surface inférieure (42) opposée à la surface supérieure (41), la puce de capteur (4) comprenant une pluralité de plages de connexion (4121) agencées sur sa surface supérieure (41), dans laquelle la taille de la puce de capteur (4) est supérieure à celle de l'au moins une puce de semi-conducteur (2), et la surface inférieure (42) de la puce de capteur (4) est fixée sur le plan porteur (321) ;
une pluralité de fils (5), chacun d'eux présentant une première extrémité et une seconde extrémité opposée à la première extrémité, dans laquelle les premières extrémités des fils (5) sont connectées respectivement aux plages de soudure (111), et les secondes extrémités des fils (5) sont connectées respectivement aux plages de connexion (4121) ;
une couche transparente (6) qui présente une première surface (61) et une seconde surface (62) opposée à la première surface (61), dans laquelle la seconde surface (62) présente une région centrale (621) et une région supportée de forme annulaire (622) qui encercle la région centrale (621) ;
un support (7) qui présente une structure de forme annulaire ;
**caractérisée en ce que**
ledit support (7) est disposé sur l'une au moins de la surface supérieure (41) de la puce de capteur (4) et de la surface porteuse du cadre (3), dans laquelle une extrémité supérieure du support (7) vient en butée contre la région supportée (622) de la couche transparente (6) ; et
un composé de boîtier (8) disposé sur la surface supérieure (11) du substrat (1), et qui couvre un côté latéral du cadre (3), une partie au moins d'un côté latéral de la couche transparente (6), et un côté latéral du support (7), dans laquelle une partie au moins de chacun des fils (5) est intégrée dans le composé de boîtier (8),
dans laquelle une partie au moins du support (7) est disposée sur la surface supérieure (41) de la puce de capteur (4), et couvre les plages de connexion (4121), et une partie de chacun des fils (5).

2. Structure de boîtier de capteur du type à empilement selon la revendication 1, dans laquelle le cadre (3) est renfoncé au niveau d'un bord du plan porteur (321), afin de former une encoche de forme annulaire (33), et l'encoche de forme annulaire (33) se situe à l'extérieur de la puce de capteur (4).

3. Structure de boîtier de capteur du type à empilement selon la revendication 1, dans laquelle une partie bord (43) de la puce de capteur (4) ne comprend aucune plage de connexion (4121), et le support (7) comprend :
une première partie support (71) disposée sur la surface supérieure (41) de la puce de capteur (4), et qui couvre les plages de connexion (4121), et une partie de chacun des fils (5) ; et
une seconde partie support (72) disposée sur le plan porteur (321), et agencée adjacente à la partie bord (43), dans laquelle la seconde partie support (72) n'entre en contact avec aucun des fils (5),
dans laquelle une extrémité supérieure de la première partie support (71), et une extrémité supérieure de la seconde partie support (72), viennent toutes deux en butée contre la région supportée (622) de la couche transparente (6) .

4. Structure de boîtier de capteur du type à empilement selon la revendication 1, dans laquelle la surface supérieure (41) de la puce de capteur (4) présente une région de détection (411), les plages de connexion (4121) sont agencées au niveau d'une périphérie de la région de détection (411), et le support (7) est disposé sur la surface supérieure (41) de la puce de capteur (4), et se situe entre la région de détection (411) et les plages de connexion (4121).

5. Structure de boîtier de capteur du type à empilement selon la revendication 1, dans laquelle le support (7) est disposé sur le plan porteur (321) du cadre (3), et se situe au niveau d'une périphérie de la puce de capteur (4), et le support (7) entoure une partie de chacun des fils (5).

6. Structure de boîtier de capteur du type à empilement selon la revendication 5, dans laquelle le support (7) comprend :
une couche support (73) disposée sur le plan porteur (321) et située au niveau de la périphérie de la puce de capteur (4) ; et
une couche connexion (74) disposée sur la couche support (73), dans laquelle une extrémité supérieure de la couche connexion (74) vient en butée contre la région supportée (622) de la couche transparente (6).

7. Structure de boîtier de capteur du type à empilement selon la revendication 6, dans laquelle une hauteur de la couche support (73) par rapport au plan porteur (321), est sensiblement égale à une hauteur de la surface supérieure (41) de la puce de capteur (4) par rapport au plan porteur (321), la partie de chacun des fils (5) est intégrée dans la couche connexion, et la couche support (73) n'entre en contact avec aucun des fils (5).

8. Structure de boîtier de capteur du type à empilement selon la revendication 1, dans laquelle le composé de boîtier (8) est un composé de moulage (83), le composé de boîtier (8) présentant une surface supérieure plane (41) plus basse que la première surface (61) de la couche transparente (6), d'une distance empêchant un débordement (D), comprise approximativement entre 50 µm et 100 µm.

9. Structure de boîtier de capteur du type à empilement selon la revendication 1, dans laquelle le composé de boîtier (8) comprend :
un composé liquide (82) qui couvre le côté latéral du cadre (3), le côté latéral de la couche transparente (6), et le côté latéral du support (7), dans laquelle le composé liquide (82) présente une surface supérieure oblique (821), et un bord de la surface supérieure oblique (821) est connecté à un bord de la couche transparente (6) ; et
un composé de moulage (83) formé sur la surface supérieure oblique (821) du composé liquide (82), le composé de moulage (83) présente une surface supérieure (831) parallèle à la première surface (61) de la couche transparente (6), et la surface supérieure (831) du composé de moulage (83) est plus basse que la première surface (61) de la couche transparente (6) d'une distance empêchant un débordement (D), comprise approximativement entre 50 µm et 100 µm.

10. Structure de boîtier de capteur du type à empilement selon la revendication 1, comprenant en outre au moins une puce intégrée (C), intégrée dans le substrat (1).

11. Structure de boîtier de capteur du type à empilement selon l'une quelconque des revendications 1 à 10, dans laquelle le cadre (3) comprend :
une base de forme annulaire (31) fixée sur le substrat (1) ; et
une plaque porteuse (32) connectée à la base de forme annulaire (31), dans laquelle une surface extérieure de la plaque porteuse (32) est définie en tant que plan porteur (321) .

12. Structure de boîtier de capteur du type à empilement selon la revendication 11, dans laquelle la plaque porteuse (32) présente un trou traversant (322), et la puce de capteur (4) blinde le trou traversant (322).

13. Structure de boîtier de capteur du type à empilement selon l'une quelconque des revendications 1 à 10, dans laquelle le substrat (1) est renfoncé à partir de sa surface supérieure (11) afin de former une encoche de réception (112), et l'au moins une puce de semi-conducteur (2) est agencée dans l'encoche de réception (112).

14. Structure de boîtier de capteur du type à empilement selon la revendication 13, dans laquelle le cadre (3) est une plaque porteuse (32) collée sur la surface supérieure (11) du substrat (1), et une surface extérieure de la plaque porteuse (32) est définie en tant que plan porteur (321) .

15. Structure de boîtier de capteur du type à empilement selon la revendication 13, dans laquelle de multiples puces de semi-conducteur (2) sont incluses dans la structure de boîtier de capteur du type à empilement (100), et les puces de semi-conducteur (2) sont connectées électriquement au substrat (1) par microcâblage.

16. Structure de boîtier de capteur du type à empilement selon la revendication 15, dans laquelle la surface supérieure (11) du substrat (1) présente une région de microcâblage (113) agencée entre le cadre (3) et l'encoche de réception (112), et l'au moins une puce de semi-conducteur (2) est connectée électriquement à la région de microcâblage (113) du substrat (1) par microcâblage.
